# EUROPEAN PATENT APPLICATION

(11) **EP 4 550 976 A1**
(43) Date of publication of application: **07.05.2025**
(21) Application number: 24210435.4
(22) Date of filing: 01.11.2024
(51) Int. Cl.: H10D 30/01, H10D 12/00, H10D 30/66, H10D 84/01, H10D 84/00, H10D 84/82

(54) **SEMICONDUCTOR DEVICE AND METHOD FOR MANUFACTURING SAME**

(30) Priority: 03.11.2023 CN 202311460246
(71) Applicant: Nexperia B.V., 6534 AB Nijmegen (NL); Nexperia Technology (Shanghai) Ltd., Shanghai 200025 (CN)
(72) Inventor: Shi, Jinshan, Shanghai (CN); Huang, Linjie, Shanghai (CN); Zhu, Chunlin, Shanghai (CN); Jiang, Ke, Shanghai (CN)
(74) Representative: Pjanovic, Ilija

(57) **Abstract**

The present invention provides a semiconductor device and a method for manufacturing the same. The semiconductor device includes an insulated-gate bipolar transistor (IGBT) structure and a metal-oxide-semiconductor (MOS) transistor structure integrated in one wafer. The MOS transistor structure is connected in parallel with the IGBT structure. A thickness of a trench insulating layer in the MOS transistor structure is less than a thickness of a trench insulating layer in the IGBT structure.

## Description

### Technical Field

The present invention belongs to the technical field of semiconductors, and particularly relates to a power semiconductor device including an insulated-gate bipolar transistor (IGBT) structure and a metal-oxide-semiconductor field-effect transistor (MOS transistor) structure and a method for manufacturing the same.

### Background

Usually, two ends of an IGBT are connected in reverse parallel with a diode, which avoids device damage caused by overvoltage when the device is turned off, reduces the reverse recovery time of the device and improves reverse recovery characteristics of the device. However, the parallel connection of the diode often requires two chips during chip packaging, which may occupy a large area during circuit integration.

In addition, for a power apparatus, reducing loss is a main task at present. The switching speed of the IGBT is low, ranging from tens of nanoseconds to hundreds of nanoseconds, but the switching speed of the MOSFET is high, reaching the level of several nanoseconds, so the MOSFET can operate under high-frequency conditions. The existing methods for increasing the switching speed of the IGBT apparatus are usually limited to adjusting the internal arrangement of the IGBT structure.

US9257549B2 discloses a method for improving reverse recovery performance of a device by integrating a diode in the chip. Specifically, the diode is integrated into the device by adding an N-type region on the back side and a second electrode on the front side, thereby realizing the reverse recovery characteristics of the single chip. However, the semiconductor device in US9257549B2 has the problems of voltage snapback and low switching speed.

### Summary

The present invention provides a semiconductor device, including an IGBT structure and an MOS transistor structure integrated in one wafer. The MOS transistor structure is connected in parallel with the IGBT structure. A thickness of a trench insulating layer in the MOS transistor structure is less than a thickness of a trench insulating layer in the IGBT structure.

According to an embodiment of the present invention, the semiconductor device further includes a PIN structure having a trench structure. The PIN structure, the IGBT structure and the MOS transistor structure are integrated in the one wafer, and the PIN structure is connected in parallel with the IGBT structure.

According to an embodiment of the present invention, the semiconductor device has a first side and a second side opposite to each other. The IGBT structure and the MOS transistor structure each include a first trench on the first side, and the first trench of the IGBT structure and the first trench of the MOS transistor structure are in electrical contact with a gate electrode. The IGBT structure includes a first semiconductor region on the second side, and the MOS transistor structure includes a second semiconductor region on the second side. The first semiconductor region and the second semiconductor region have doping types opposite to each other.

According to an embodiment of the present invention, the semiconductor device further includes a trench insulating layer located on an inner wall of the first trench of the IGBT structure and a trench insulating layer located on an inner wall of the first trench of the MOS transistor structure. A thickness of the trench insulating layer located in the first trench of the MOS transistor structure is less than a thickness of the trench insulating layer located in the first trench of the IGBT structure.

According to an embodiment of the present invention, the semiconductor device has a first side and a second side opposite to each other. The semiconductor device includes a common source metal layer located on the first side and a common drain metal layer located on the second side. The IGBT structure and the MOS transistor structure each include a first trench on the first side. The first trench of the IGBT structure and the first trench of the MOS transistor structure are in electrical contact with a gate electrode. The PIN structure includes a second trench on the first side. The second trench is in electrical contact with the common source metal layer. The IGBT structure includes a first semiconductor region on the second side, and the MOS transistor structure and the PIN structure each include a second semiconductor region on the second side. A doping type of the first semiconductor region of the IGBT structure and a doping type of the respective second semiconductor regions of the MOS transistor structure and the PIN structure are opposite to each other, and the first semiconductor region of the IGBT structure, the second semiconductor region of the MOS transistor structure and the second semiconductor region of the PIN structure are all in electrical contact with the common drain metal layer.

According to an embodiment of the present invention, the semiconductor device further includes trench insulating layers located on inner walls of the first trench and the second trench. A thickness of the trench insulating layer located in the first trench of the MOS transistor structure and the trench insulating layer located in the second trench is less than a thickness of the trench insulating layer located in the first trench of the IGBT structure.

According to an embodiment of the present invention, the MOS transistor structure is located between the IGBT structure and the PIN structure.

According to an embodiment of the present invention, the PIN structure is located between the IGBT structure and the MOS transistor structure.

According to an embodiment of the present invention, in a plan layout of the semiconductor device, the IGBT structure is located at a center of the semiconductor device, and the MOS transistor structure and the PIN structure are arranged around the IGBT structure.

According to an embodiment of the present invention, in a plan layout of the semiconductor device, the PIN structure, the MOS transistor structure and the IGBT structure are all strip-shaped, and each side of the IGBT structure in its width direction is provided with the PIN structure or the MOS transistor structure.

According to an embodiment of the present invention, the semiconductor device includes a semiconductor body having a first surface located on the first side. The first trench and the second trench extend into the semiconductor body from the first surface. The first trench further includes a gate material located inside the trench insulating layer, and the second trench further includes a dummy gate material located inside the trench insulating layer.

The present invention further provides a method for manufacturing a semiconductor device, including: forming a first region of a semiconductor substrate as an IGBT structure, and forming a second region of the semiconductor substrate as an MOS transistor structure connected in parallel with the IGBT structure. A thickness of a trench insulating layer in the MOS transistor structure is less than a thickness of a trench insulating layer in the IGBT structure.

According to an embodiment of the present invention, the method further includes: forming a PIN structure in a third region of the semiconductor substrate, the PIN structure being connected in parallel with the IGBT structure.

According to an embodiment of the present invention, the semiconductor device has a first side and a second side opposite to each other, and the method further includes: forming a first trench of the IGBT structure, a first trench of the MOS transistor structure and a second trench of the PIN structure on the first side of the semiconductor substrate, the first trench of the IGBT structure and the first trench of the MOS transistor structure being both in electrical contact with a gate electrode, and the second trench of the PIN structure being in electrical contact with a common source metal layer located on the first side of the semiconductor device; and forming a first semiconductor region of the IGBT structure and second semiconductor regions of the MOS transistor structure and the PIN structure on the second side of the semiconductor substrate opposite to the first side, where the first semiconductor region and the second semiconductor regions have opposite doping types and are in electrical contact with a common drain metal layer located on the second side of the semiconductor device.

According to an embodiment of the present invention, the method further includes: forming trench insulating layers on inner walls of the first trench of the IGBT structure, the first trench of the MOS transistor structure and the second trench of the PIN structure; and etching the trench insulating layer located in the first trench of the MOS transistor structure and the trench insulating layer located in the second trench of the PIN structure such that a thickness of the trench insulating layer located in the first trench of the MOS transistor structure and the trench insulating layer located in the second trench of the PIN structure is less than a thickness of the trench insulating layer located in the first trench of the IGBT structure.

According to an embodiment of the present invention, the step of forming the first semiconductor region of the IGBT structure and the second semiconductor regions of the MOS transistor structure and the PIN structure includes: performing doping treatment on the second side of the semiconductor substrate with a photomask to form the first semiconductor region of a first doping type and the second semiconductor regions of a second doping type.

### Brief Description of Figures

FIG. 1 is a sectional view of a semiconductor device according to an embodiment of the present invention;
FIG. 2 is a sectional view of a semiconductor device according to another embodiment of the present invention;
FIG. 3 is a comparison diagram of semiconductor devices in the hybrid IGBT structure shown in FIG. 2 and an existing RC-IGBT structure;
FIG. 4a to FIG. 4k are intermediate structural views of a method for manufacturing a semiconductor device according to an embodiment of the present invention;
FIG. 5 is a sectional view of a semiconductor device according to another embodiment of the present invention;
FIG. 6 is a sectional view of a semiconductor device according to another embodiment of the present invention;
FIG. 7 is a sectional view of a semiconductor device according to another embodiment of the present invention;
FIG. 8 is a layout diagram of a semiconductor device according to an embodiment of the present invention; and
FIG. 9 is a layout diagram of a semiconductor device according to another embodiment of the present invention.

### Detailed Description

In order to make those skilled in the art better understand the technical solutions of the present invention, as a non-limiting example, the semiconductor device provided by the invention will be described in detail with reference to the accompanying drawings.

It should also be noted that in order to illustrate these exemplary embodiments here, the views will show the general features of the method and the device of the exemplary embodiments of the present invention. However, these views are not to scale and may not accurately reflect the features of any given embodiment, and should not be interpreted as defining or limiting the numerical range or characteristics of exemplary embodiments within the scope of the present invention.

The terms "having", "comprising", "including", "containing" and the like are open-ended, and these terms indicate the existence of the stated structure, element or feature, but do not exclude the existence of additional elements or features. The article "a", "an" or "the" is intended to include the plural as well as the singular, unless the context clearly indicates otherwise.

In the present invention, the first doping type is P-type, and the second doping type is N-type. The P-type doping and the N-type doping may be called mutually opposite doping types. That is, the P-type doped semiconductor is multi-hole, and the N-type doped semiconductor is multi-electron. The two different doped semiconductors have opposite electrical characteristics. It can be understood that the present invention is not limited to this, that is, the first doping type may be N-type and the second doping type may be P-type. In some accompanying drawings, the relative doping concentration is denoted by marking "-" or "+" after the doping type. For example, the doping concentration of an "n-" doped region is lower than the doping concentration of an "n" doped region, and the doping concentration of an "n+" doped region is higher than the doping concentration of an "n" doped region. However, the doped regions represented by the same relative doping concentration symbol do not necessarily have the same absolute doping concentration. For example, two different "n-" doped regions may have different absolute doping concentrations.

"Connected in parallel" herein means that two semiconductor unit structures are connected in parallel with each other in electrical performance and arranged side by side in the physical structure of the wafer.

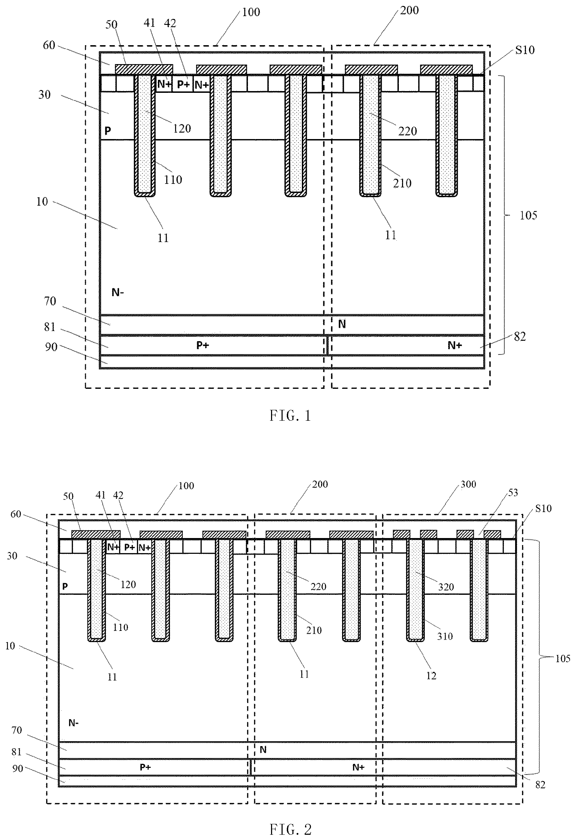

In one aspect, the present invention provides a semiconductor device. As shown in FIG. 1, the semiconductor device includes an IGBT structure 100 and an MOS transistor structure 200. The IGBT structure 100 and the MOS transistor structure 200 are connected in parallel in one wafer.

The semiconductor device has a first side and a second side (e.g., a top side and a bottom side in the sectional view of FIG. 1) opposite to each other. On the first side (e.g., the top side in FIG. 1), the IGBT structure 100 and the MOS transistor structure 200 each include a first trench 11. The first trenches 11 are in electrical contact with a gate electrode. In the present invention, the specific structure of the first trench in the IGBT structure and the specific structure of the first trench in the MOS transistor structure may be the same, similar or different, but the first trench in the IGBT structure and the first trench in the MOS transistor structure are both connected to a gate of the semiconductor device, and thus are collectively called the first trench. Specifically, in the IGBT structure 100, an inner wall of the first trench 11 is provided with a trench insulating layer 110 and a gate material 120 located inside the trench insulating layer 110. In the MOS transistor structure 200, an inner wall of the first trench 11 is provided with a trench insulating layer 210 and a gate material 220 located inside the trench insulating layer 210. The gate material 120 in the IGBT structure 100 and the gate material 220 in the MOS transistor structure are connected to the same gate electrode, for example, may be connected to a gate pad, or a gate ring connected between an active region and a terminal region by means of plan view design.

In the present invention, the trench insulating layer 210 located in the first trench 11 of the MOS transistor structure 200 and the trench insulating layer 110 located in the first trench 11 of the IGBT structure 100 have substantially uniform thicknesses, and the thickness of the trench insulating layer 210 and the thickness of the trench insulating layer 110 may be adjusted according to actual needs.

In an embodiment of the present invention, the thickness of the trench insulating layer 210 located in the first trench 11 of the MOS transistor structure 200 is less than the thickness of the trench insulating layer 110 located in the first trench 11 of the IGBT structure 100. Since the trench insulating layer 210 in the MOS transistor structure 200 is thinner than a gate oxide layer 110 in the IGBT structure 100, when the semiconductor device is turned on in the reverse direction, more carriers may flow through the MOS channel. The trench insulating layer includes, for example, an oxide layer.

In addition, in an embodiment of the present invention, on the second side (e.g., the bottom side in FIG. 1) of the semiconductor device, the IGBT structure 100 includes a first collector region 81 of a first doping type, and the MOS transistor structure 200 includes a second collector region 82 of a second doping type. The first collector region 81 and the second collector region 82 are located on a same layer, and the first doping type and the second doping type are opposite to each other. The first collector region 81 and the second collector region 82 are in electrical contact with a collector 90. By making the first collector region 81 and the second collector region 82 have opposite doping types, the reverse recovery characteristics of the semiconductor device can be improved.

In the semiconductor device according to the present invention, the IGBT structure 100 and the MOS transistor structure 200 are connected in parallel and integrated in one wafer. When the semiconductor device is turned on in the forward direction, compared with the IGBT structure, the MOS transistor structure is turned on first, and the current flows through the MOS transistor structure first, which greatly increases the turn-on speed of the semiconductor device.

The semiconductor device according to the present invention includes a semiconductor body 105 having a first surface S10 located on the first side. The first trench 11 extends into the semiconductor body 105 from the first surface S10.

As shown in FIG. 1, from the second side to the first side, the semiconductor body 105 sequentially includes: the first collector region 81 of the first doping type and the second collector region 82 of the second doping type, a buffer layer 70 of the second doping type located in the first collector region 81 and the second collector region 82, a lightly doped drift layer 10 of the second doping type located on a side of the buffer layer 70 away from the first collector region 81 and the second collector region 82, a body region 30 of the first doping type located on a side of the drift layer 10 away from the buffer layer 70, and heavily doped regions 41 of the second doping type and a heavily doped region 42 of the first doping type located on a side of the body region 30 away from the lightly doped drift layer 10. The heavily doped regions 41 of the second doping type are located on two sides of the first trench 11, and the heavily doped region 42 of the first doping type is located between the two adjacent heavily doped regions 41 of the second doping type. The first trench 11 extends longitudinally from the first side to the second side through the body region 30 into the drift layer 10. On two sides of the semiconductor body 105, the collector 90 (on the second side, a conductive electrode formed on the semiconductor body) and an emitter 60 (on the first side) are respectively arranged. The emitter 60 and the collector 90 are metal layers arranged on the two sides of the semiconductor body 105, and are shared by the IGBT structure and the MOS transistor structure. Therefore, the emitter 60 in the present invention is also called a common source metal layer arranged on the first side of the semiconductor body 105, and the collector 90 is also called a common drain metal layer arranged on the second side of the semiconductor body 105. The gate materials 120, 220 in the first trenches 11 are insulated from the emitter 60 by an interlayer insulating film 50 arranged therebetween.

In another aspect, the present invention further provides a semiconductor device. As shown in FIG. 2, the semiconductor device includes an IGBT structure 100, an MOS transistor structure 200 and a positive-intrinsic-negative (PIN) structure 300. The MOS transistor structure 200 and the PIN structure 300 are connected in parallel with the IGBT structure 100 in one wafer. That is, compared with the semiconductor device shown in FIG. 1, the semiconductor device shown in FIG. 2 further includes the PIN structure 300 connected in parallel with the IGBT structure 100 in one wafer.

The embodiment of FIG. 2 is similar to the embodiment of FIG. 1. The semiconductor device has a first side and a second side (e.g., a top side and a bottom side in the sectional view of FIG. 2) opposite to each other. Specifically, the IGBT structure 100 and the MOS transistor structure 200 in the embodiment of FIG. 2 are the same as those in FIG. 1. What is different from the embodiment shown in FIG. 1 is that on the first side (e.g., the top side in FIG. 2), the semiconductor device further includes the PIN structure 300. The PIN structure 300 includes a second trench 12, and the second trench 12 is in electrical contact with the common source metal layer. Specifically, in the PIN structure, an inner wall of the second trench 12 is provided with a trench insulating layer 310 and a gate material 320 located inside the trench insulating layer 310. The gate material 320 in the PIN structure 300 is connected to the emitter 60.

In the present invention, the trench insulating layer 310 located in the second trench 12 of the PIN structure also has a substantially uniform thickness, and the thickness of the trench insulating layer 310 may be adjusted according to actual needs.

In this embodiment of the present invention, the thickness of the trench insulating layer 210 located in the first trench 11 of the MOS transistor structure and the thickness of the trench insulating layer 310 located in the second trench 12 of the PIN structure are respectively less than the thickness of the trench insulating layer 110 located in the first trench 11 of the IGBT structure. In addition, the thickness of the trench insulating layer 210 located in the first trench 11 of the MOS transistor structure and the thickness of the trench insulating layer 310 located in the second trench 12 of the PIN structure may be the same or different, which is not limited in the present invention.

In addition, in this embodiment of the present invention, on the second side (e.g., the bottom side in FIG. 2) of the semiconductor device, the PIN structure 300 also includes a second collector region 82, and the first collector region 81 in the IGBT structure 100 and the second collector regions 82 in the MOS transistor structure 200 and the PIN structure 300 are located on a same layer and have opposite doping types. The first collector region 81 and the second collector region 82 are in electrical contact with the collector 90.

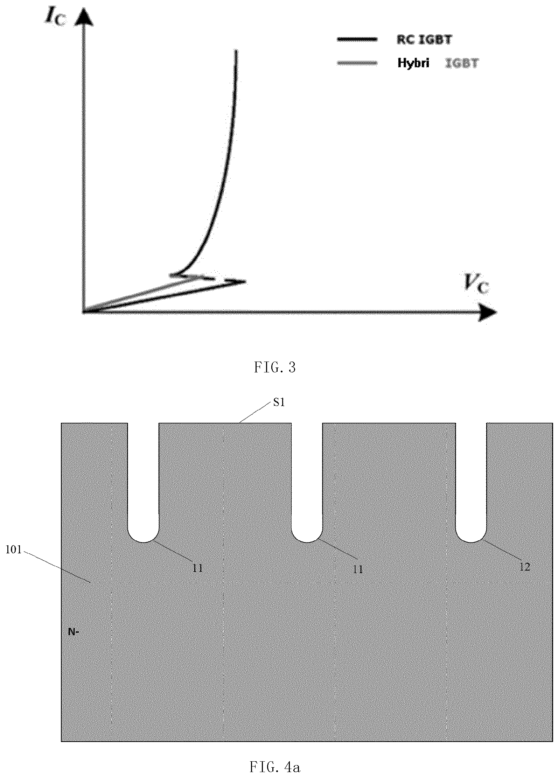

In the semiconductor device according to the present invention, the MOS transistor structure 200 and the PIN structure 300 are connected in parallel with the IGBT structure 100 in one wafer. When the semiconductor device is turned on in the forward direction, compared with the IGBT structure, the MOS transistor structure is turned on first, and the current flows through the MOS transistor structure first, which greatly increases the turn-on speed of the semiconductor device. During the reverse recovery of the semiconductor device, a high reverse current quickly flows through the PIN structure, which greatly shortens the reverse recovery time. By integrating the IGBT structure and the PIN structure in one wafer, they share one terminal, which reduces the size of the chip. After the PIN structure is added to the IGBT structure, this structure is equivalent to an RC-IGBT, which always has the problem of voltage snapback. However, since the MOS transistor structure is also integrated in the semiconductor device of the present invention, the problem of voltage snapback can be alleviated. This is because before the PN junction on the back side of the IGBT structure is turned on, many electrons have passed through the back side of the MOS transistor structure. As shown in FIG. 3, when the collector voltage Vc increases, the semiconductor device according to the present invention exhibits higher collector current Ic due to the existence of the MOS transistor structure. As the resistance of the body decreases, the PN junction on the back side of the IGBT structure receives more voltage from Vc, less voltage is needed to turn on the PN junction on the back side, as shown by gray lines. The semiconductor device (hybrid IGBT) including the IGBT structure, the PIN structure and the MOS transistor structure is turned off only earlier than the device (RC-IGBT) including the IGBT structure and the PIN structure, which means that the voltage snapback is alleviated.

The semiconductor device according to the present invention includes a semiconductor body 105. As shown in FIG. 2, the semiconductor body 105 has a first surface S10 located on the first side. Similar to the first trench 11, the second trench 12 extends into the semiconductor body 105 from the first surface S10.

The structure of the semiconductor body 105 shown in FIG. 2 is similar to the structure shown in FIG. 1, except that: the heavily doped regions 41 of the second doping type are further located on two sides of the second trench 12, the second trench 12 extends longitudinally through the body region 30 into the drift layer 10, and the gate material 320 (dummy gate) in the second trench 12 and the emitter 60 are connected by means of an opening 53 in the interlayer insulating film 50 arranged therebetween.

A method for manufacturing a semiconductor device will be described below in an example of a semiconductor device including an IGBT structure, an MOS transistor structure and a PIN structure.

In step S101, as shown in FIG. 4a, a first trench 11 and a second trench 12 are formed on a first surface S1 of a lightly doped semiconductor substrate 101 of a second doping type by etching. The first trench 11 and the second trench 12 extend into the semiconductor substrate 101 from the first surface S1. The first trench 11 and the second trench 12 may have the same size.

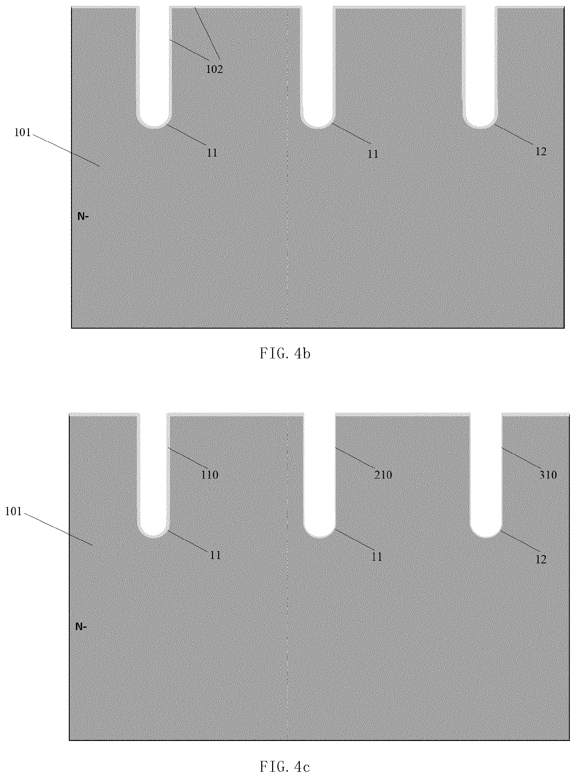

In step S102, as shown in FIG. 4b, an oxide layer 102 is formed on inner walls of the first trench 11 and the second trench 12 and the first surface S1 of the semiconductor substrate 101. A material of the oxide layer may be SiO₂ or any other appropriate oxide, and a thickness of the oxide layer may be set according to actual needs.

In step S103, as shown in FIG. 4c, the thicknesses of the oxide layer 102 in the second trench 12 and the oxide layer 102 in the first trench 11 of the MOS transistor structure are reduced to form a trench insulating layer 110 in the first trench 11 of the IGBT structure, a trench insulating layer 210 in the first trench 11 of the MOS transistor structure and a trench insulating layer 310 in the second trench 12 of the PIN structure. The thickness reduction step may be implemented, for example, by etching. Through this step, the thickness of the trench insulating layer 110 in the first trench 11 of the IGBT structure is greater than the thickness of the trench insulating layer 210 in the first trench 11 of the MOS transistor structure and the thickness of the trench insulating layer 310 in the second trench 12 of the PIN structure. The thickness of the trench insulating layer 210 located in the first trench 11 of the MOS transistor structure and the thickness of the trench insulating layer 310 located in the second trench 12 of the PIN structure may be the same or different, which is not limited in the present invention.

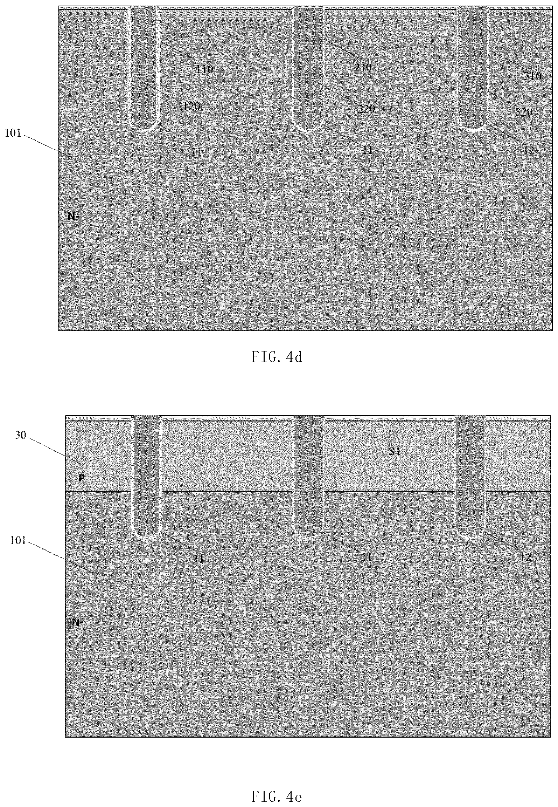

In step S104, as shown in FIG. 4d, gate materials 120, 220 and 320 may be respectively formed inside the trench insulating layers 110, 210 and 310, for example, by deposition. The gate materials may be polysilicon.

In step S105, as shown in FIG. 4e, a body region 30 of a first doping type is formed in the lightly doped semiconductor substrate 101 of the second doping type on a side near the first surface, for example, by ion implantation.

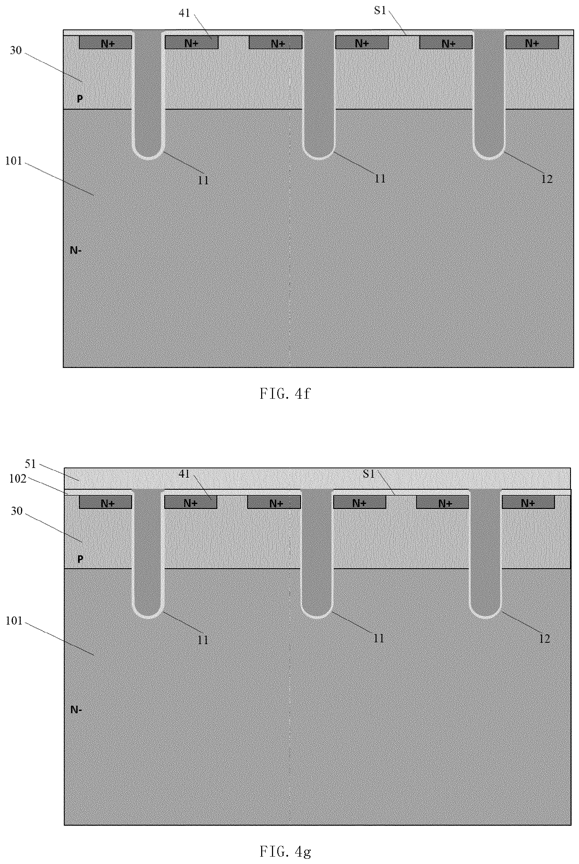

In step S106, as shown in FIG. 4f, heavily doped regions 41 of the second doping type are formed in the body region 30 near the first surface S1, the first trench 11 and the second trench 12, for example, by ion implantation. The heavily doped regions 41 of the second doping type are located on two sides of each of the first trench 11 and the second trench 12.

In step S107, as shown in FIG. 4g, an insulating layer 51 is formed on the first surface S1 of the semiconductor substrate 101. The insulating layer 51 covers the oxide layer 102 on the first surface S1 of the semiconductor substrate 101, the first trench 11 and the second trench 12.

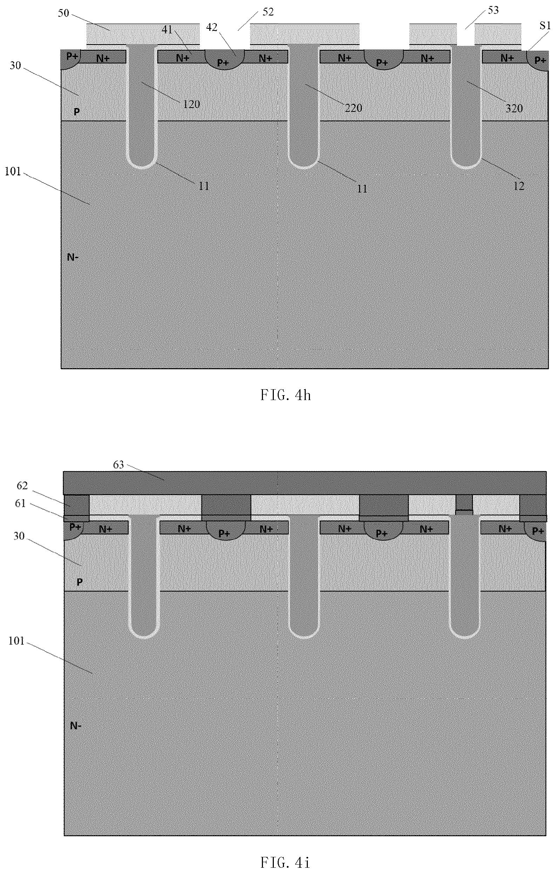

In step S108, as shown in FIG. 4h, the insulating layer 51 and the oxide layer 102 located on the first surface S1 of the semiconductor substrate 101 are patterned to form an interlayer insulating film 50. The interlayer insulating film 50 covers the first trench 11, the second trench 12, and at least a part of the heavily doped regions 41 of the second doping type, and includes a first opening 52 and a second opening 53. The first opening 52 exposes regions of the first surface S1 where the heavily doped regions 41 of the second doping type are not formed. The second opening 53 exposes the gate material 320 in the second trench 12. The gate materials 120, 220 in the first trenches 11 are completely covered by the interlayer insulating film 50.

Next, a heavily doped region 42 of the first doping type is formed between the adjacent heavily doped region 41 of the second doping type.

In step S109, as shown in FIG. 4i, conductive layers 61, 62 and 63 are respectively formed on a side of the interlayer insulating film 50 away from the semiconductor substrate to form a common source metal layer. A material of the conductive layer 62 is tungsten. Compared with other metals, it is easier for tungsten to fill deep holes, which is convenient for through-hole connection. The conductive layers 61 and 63 may be made of the same material.

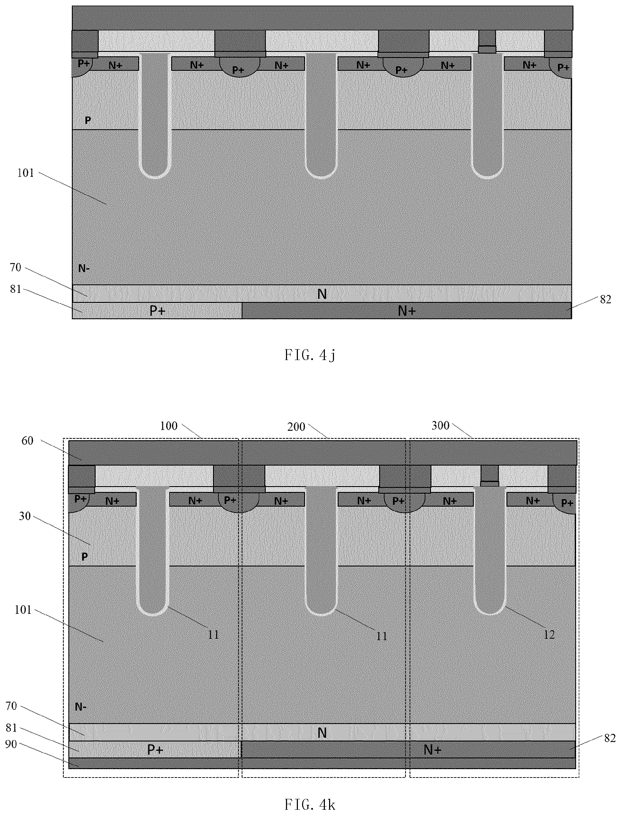

In step S110, as shown in FIG. 4j, a first collector region 81 of the first doping type, a second collector region 82 of the second doping type and a buffer layer 70 of the second doping type are formed on a side of the semiconductor substrate opposite to the first surface. Impurities of the first doping type and the second doping type may be implanted in the collector regions by using a photomask to form the alternating collector regions 81 of the first doping type and collector regions 82 of the second doping type. In the present invention, the sequence of forming the collector region and the buffer layer is not limited.

In step S111, as shown in FIG. 4k, a collector 90 is formed outside the first collector region 81 and the second collector region 81 of the second doping type.

Thereby, the semiconductor device including the IGBT structure 100, the MOS transistor structure 200 and the PIN structure 300 is formed.

Therefore, the semiconductor device according to the present invention may be formed by making the following modifications on the basis of the conventional IGBT manufacturing method:

1. In the step of forming the gate oxide, the thicknesses of the trench insulating layers in part of the gate trenches are reduced (for example, by etching) to obtain the gate oxide in the MOS transistor structure and the gate oxide in the PIN structure.

2. During the treatment of the back side, the impurities of the first doping type and the second doping type may be implanted in the collector regions by using a photomask to form the alternating collector regions of the first doping type and collector regions of the second doping type.

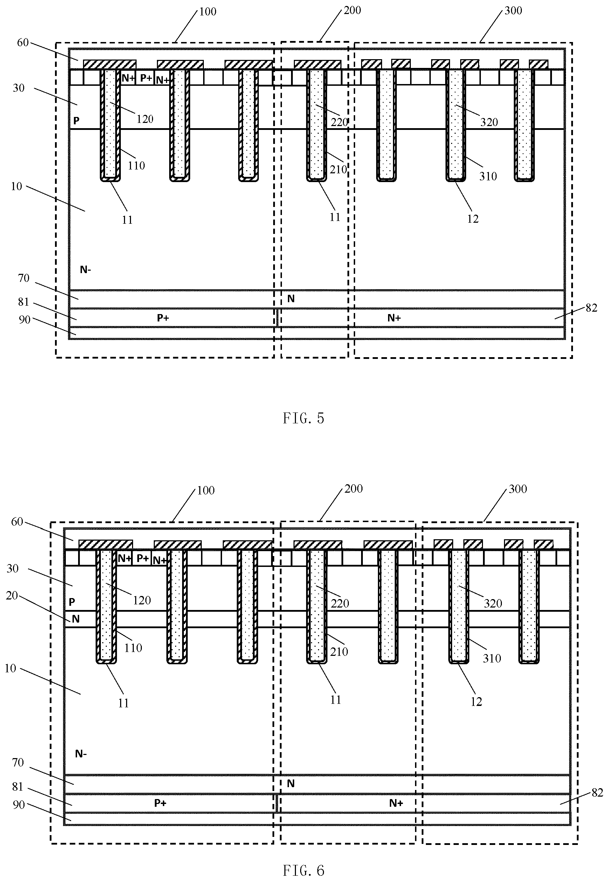

In the embodiments of the present invention, the proportion of the MOS transistor structure and the PIN structure in the semiconductor device may be set according to needs, for example, according to the desired reverse recovery characteristics or switching speed. FIG. 5 shows an example where the MOS transistor structure only includes one trench structure and the IGBT structure and the PIN structure each include 2 trench structures. The present invention is not limited thereto.

The semiconductor device according to the present invention may also be applied to other IGBT structures, for example, the carrier storage IGBT structure shown in FIG. 6. Compared with the semiconductor device shown in FIG. 1, the semiconductor device of FIG. 6 further includes a carrier storage layer 20 of the first doping type located between the body region 30 and the drift layer 10.

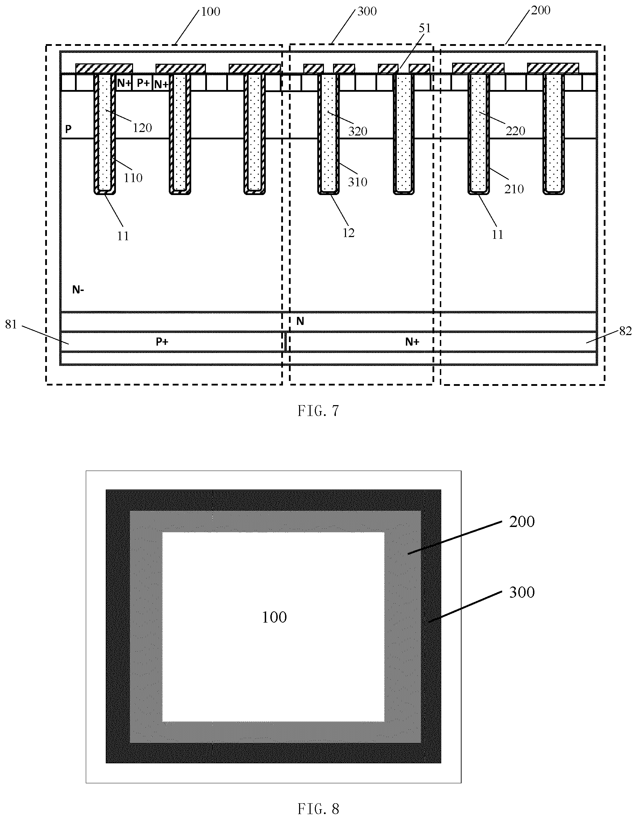

In the embodiment shown in FIG. 2, the MOS transistor structure 200 is adjacent to the IGBT structure 100, and the PIN structure 300 is located on a side of the MOS transistor structure 200 away from the IGBT structure 100. However, the present invention is not limited thereto. The positions of the MOS transistor structure 200 and the PIN structure 300 may also be exchanged. As shown in FIG. 7, the PIN structure 300 may be adjacent to the IGBT structure 100, and the MOS transistor structure 200 is located on a side of the PIN structure 300 away from the IGBT structure 100.

In one embodiment of the present invention, in the plan view (i.e., the top view of the chip, which may also be called the plan layout of the semiconductor device) from the first side to the second side of the semiconductor device, the IGBT structure 100 is located at a center of the semiconductor device, and the MOS transistor structure 200 and the PIN structure 300 are arranged around the IGBT structure 100. As shown in FIG. 8, the MOS transistor structure 200 surrounds the IGBT structure 100, and the PIN structure 300 further surrounds the MOS transistor structure 200. It can be understood that the positions of the MOS transistor structure 200 and the PIN structure 300 may also be exchanged. In FIG. 8, the IGBT structure 100 is rectangular in shape, and the MOS transistor structure 200 and the PIN structure 300 are in a rectangular ring shape. The present invention is not limited thereto, there may be other appropriate shapes. It can be understood that the "plan layout of the semiconductor device" in the present invention refers to the plan view of the semiconductor device, i.e., the top view of the chip.

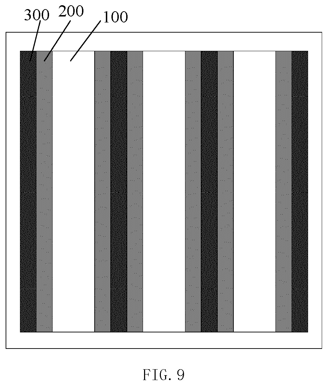

In another embodiment of the present invention, in the plan view from the first side to the second side of the semiconductor device, the IGBT structure 100, the MOS transistor structure 200 and the PIN structure 300 are all strip-shaped, and each side of the IGBT structure 100 in its width direction is provided with the PIN structure 300 or the MOS transistor structure 200. As shown in FIG. 9, each side of the IGBT structure 100 in its width direction is provided with the MOS transistor structure 200, and the side of the MOS transistor structure 200 away from the IGBT structure 100 is provided with the PIN structure 300. It can be understood that the positions of the MOS transistor structure 200 and the PIN structure 300 may also be exchanged, i.e., each side of the IGBT structure 100 in its width direction may be provided with the PIN structure 300, and the side of the PIN structure 300 away from the IGBT structure 100 is provided with the MOS transistor structure 200.

Finally, it should be noted that the above embodiments are used only to illustrate, but not to limit the technical solutions of the present invention. Although the present invention has been described in detail with reference to the foregoing embodiments, those skilled in the art should understand that the technical solutions described in the foregoing embodiments can still be modified or equivalently substituted for some or all of the technical features. For example, the features of the dependent claims can be freely substituted and/or combined as required. These modifications and substitutions do not depart from the scope of the technical solutions of the embodiments of the present invention.

**List of reference numerals:**

| Component | Numeral |
|---|---|
| IGBT structure | 100 |
| MOS transistor structure | 200 |
| PIN structure | 300 |
| First trench | 11 |
| Second trench | 12 |
| Trench insulating layer | 110 |
| Gate material | 120 |
| Trench insulating layer | 210 |
| Gate material | 220 |
| Trench insulating layer | 310 |
| Gate material | 320 |
| Carrier storage layer | 20 |
| Body region | 30 |
| Heavily doped region of second doping type | 41 |
| Heavily doped region of first doping type | 42 |
| Interlayer insulating film | 50 |
| Insulating layer | 51 |
| First opening | 52 |
| Second opening | 53 |
| Emitter | 60 |
| First conductive layer | 61 |
| Second conductive layer | 62 |
| Third conductive layer | 63 |
| Buffer layer | 70 |
| First collector region | 81 |
| Second collector region | 82 |
| Collector | 90 |
| Semiconductor substrate | 101 |
| Oxide layer | 102 |

## Claims

1. A semiconductor device, comprising:
an insulated-gate bipolar transistor (IGBT) structure and a metal-oxide-semiconductor (MOS) transistor structure integrated in one wafer, the MOS transistor structure being connected in parallel with the IGBT structure,
wherein a thickness of a trench insulating layer in the MOS transistor structure is less than a thickness of a trench insulating layer in the IGBT structure.

2. The semiconductor device according to claim 1, further comprising a PIN structure having a trench structure, wherein the PIN structure, the IGBT structure and the MOS transistor structure are integrated in the one wafer, and the PIN structure is connected in parallel with the IGBT structure.

3. The semiconductor device according to claim 1, wherein
the semiconductor device has a first side and a second side opposite to each other;
the IGBT structure and the MOS transistor structure each comprise a first trench on the first side, and the first trench of the IGBT structure and the first trench of the MOS transistor structure are in electrical contact with a gate electrode; and
the IGBT structure comprises a first semiconductor region on the second side, and the MOS transistor structure comprises a second semiconductor region on the second side, the first semiconductor region and the second semiconductor region having doping types opposite to each other.

4. The semiconductor device according to claim 3, further comprising a trench insulating layer located on an inner wall of the first trench of the IGBT structure and a trench insulating layer located on an inner wall of the first trench of the MOS transistor structure,
wherein a thickness of the trench insulating layer located in the first trench of the MOS transistor structure is less than a thickness of the trench insulating layer located in the first trench of the IGBT structure.

5. The semiconductor device according to claim 2, wherein
the semiconductor device has a first side and a second side opposite to each other;
the semiconductor device comprises a common source metal layer located on the first side and a common drain metal layer located on the second side;
the IGBT structure and the MOS transistor structure each comprise a first trench on the first side, the first trench of the IGBT structure and the first trench of the MOS transistor structure being in electrical contact with a gate electrode; the PIN structure comprises a second trench on the first side, the second trench being in electrical contact with the common source metal layer; and
the IGBT structure comprises a first semiconductor region on the second side, and the MOS transistor structure and the PIN structure each comprise a second semiconductor region on the second side, a doping type of the first semiconductor region of the IGBT structure and a doping type of the second semiconductor regions of the MOS transistor structure and the PIN structure being opposite to each other, and the first semiconductor region of the IGBT structure, the second semiconductor region of the MOS transistor structure and the second semiconductor region of the PIN structure being all in electrical contact with the common drain metal layer.

6. The semiconductor device according to claim 5, further comprising trench insulating layers located on inner walls of the first trench and the second trench,
wherein a thickness of the trench insulating layer located in the first trench of the MOS transistor structure and the trench insulating layer located in the second trench is less than a thickness of the trench insulating layer located in the first trench of the IGBT structure.

7. The semiconductor device according to any one of claims 2 to 6, wherein the MOS transistor structure is located between the IGBT structure and the PIN structure.

8. The semiconductor device according to any one of claims 2 to 6, wherein the PIN structure is located between the IGBT structure and the MOS transistor structure.

9. The semiconductor device according to claim 7 or 8, wherein in a plan layout of the semiconductor device, the IGBT structure is located at a center of the semiconductor device, and the MOS transistor structure and the PIN structure are arranged around the IGBT structure.

10. The semiconductor device according to claim 7 or 8, wherein in a plan layout of the semiconductor device, the PIN structure, the MOS transistor structure and the IGBT structure are all strip-shaped, and each side of the IGBT structure in its width direction is provided with the PIN structure or the MOS transistor structure.

11. The semiconductor device according to claim 6, comprising a semiconductor body having a first surface located on the first side,
wherein the first trench and the second trench extend into the semiconductor body from the first surface, the first trench further comprising a gate material located inside the trench insulating layer, and the second trench further comprising a dummy gate material located inside the trench insulating layer.

12. A method for manufacturing a semiconductor device, comprising:
forming a first region of a semiconductor substrate as an IGBT structure, and forming a second region of the semiconductor substrate as an MOS transistor structure connected in parallel with the IGBT structure,
wherein a thickness of a trench insulating layer in the MOS transistor structure is less than a thickness of a trench insulating layer in the IGBT structure.

13. The method according to claim 12, further comprising:
forming a PIN structure in a third region of the semiconductor substrate, the PIN structure being connected in parallel with the IGBT structure.

14. The method according to claim 13, wherein the semiconductor device has a first side and a second side opposite to each other, and the method further comprises:
forming a first trench of the IGBT structure, a first trench of the MOS transistor structure and a second trench of the PIN structure on the first side of the semiconductor substrate, the first trench of the IGBT structure and the first trench of the MOS transistor structure being both in electrical contact with a gate electrode, and the second trench of the PIN structure being in electrical contact with a common source metal layer located on the first side of the semiconductor device; and
forming a first semiconductor region of the IGBT structure and second semiconductor regions of the MOS transistor structure and the PIN structure on the second side of the semiconductor substrate opposite to the first side, wherein the first semiconductor region and the second semiconductor regions have opposite doping types and are in electrical contact with a common drain metal layer located on the second side of the semiconductor device.

15. The method according to claim 14, further comprising:
forming trench insulating layers on inner walls of the first trench of the IGBT structure, the first trench of the MOS transistor structure and the second trench of the PIN structure; and
etching the trench insulating layer located in the first trench of the MOS transistor structure and the trench insulating layer located in the second trench of the PIN structure such that a thickness of the trench insulating layer located in the first trench of the MOS transistor structure and the trench insulating layer located in the second trench of the PIN structure is less than a thickness of the trench insulating layer located in the first trench of the IGBT structure.

16. The method according to claim 14, wherein the step of forming the first semiconductor region of the IGBT structure and the second semiconductor regions of the MOS transistor structure and the PIN structure comprises:
performing doping treatment on the second side of the semiconductor substrate with a photomask to form the first semiconductor region of a first doping type and the second semiconductor regions of a second doping type.
